(19) **Europäisches Patentamt**
**European Patent Office**
**Office européen des brevets**

(11) **EP 2 192 417 B1**

(12) **EUROPÄISCHE PATENTSCHRIFT**

(45) Veröffentlichungstag und Bekanntmachung des Hinweises auf die Patenterteilung:
**25.01.2012  Patentblatt 2012/04**

(51) Int Cl.:
***G01R 33/07*** *(2006.01)*

(21) Anmeldenummer: **09176293.0**

(22) Anmeldetag: **18.11.2009**

(54) **Vertikaler Hallsensor**

Vertical hall sensor

Capteur Hall vertical

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **28.11.2008  CH 18822008**

(43) Veröffentlichungstag der Anmeldung:
**02.06.2010  Patentblatt 2010/22**

(73) Patentinhaber: **Melexis Technologies NV**
**3980 Tessenderlo (BE)**

(72) Erfinder: **Schott, Christian**
**1167, Lussy-sur-Morges (CH)**

(74) Vertreter: **Falk, Urs**
**Patentanwaltsbüro Dr. Urs Falk**
**Eichholzweg 9A**
**6312 Steinhausen (CH)**

(56) Entgegenhaltungen:
**EP-A1- 0 954 085    WO-A1-2004/025742**
**DE-C1- 10 150 955    JP-A- 2007 027 515**

## Beschreibung

Die Erfindung betrifft einen vertikalen Hallsensor, der in einen Halbleiterchip integriert ist.

Ein solcher vertikaler Hallsensor ist ein Magnetfeldsensor, der empfindlich ist auf ein Magnetfeld, das parallel zur Oberfläche des Halbleiterchips verläuft. Der Hallsensor besteht in der Regel aus einer n-dotierten Wanne, die in ein p-dotiertes Substrat eingebettet ist, oder einer p-dotierten Wanne, die in ein n-dotiertes Substrat eingebettet ist. Die Wanne weist typischerweise vier oder fünf Kontakte auf, die entlang einer Geraden angeordnet sind und sich an der Oberfläche des Substrats befinden. Zwei oder drei der vier Kontakte sind Stromkontakte, die dazu dienen, einen Strom durch den Hallsensor fliessen zu lassen, und zwei der anderen Kontakte sind Spannungskontakte, die dazu dienen, die Hallspannung abzugreifen, die bei einem Magnetfeld entsteht, das senkrecht zur Richtung des Stromes und senkrecht zur Oberfläche des Halbleiterchips verläuft.

Die am häufigsten verwendeten vertikalen Hallsensoren weisen vier Kontakte oder fünf Kontakte oder allenfalls sechs Kontakte auf und sind aus der Literatur, einschliesslich der Patentliteratur, hinreichend bekannt.

Eine der schwierigsten Aufgaben bei der Entwicklung der vertikalen Hallsensoren bestand darin und besteht noch immer darin, die Lage und Grösse der Kontakte derart festzulegen, dass der so genannte Offset des Sensorsignals, das ist die bei Abwesenheit eines Magnetfeldes zwischen den Spannungskontakten anliegende Spannung, möglichst gering ist. Diese Aufgabe ist umso schwieriger, je dünner die in das Substrat eingebettete Wanne ist. Diese Wanne, die das magnetfeldempfindliche Gebiet des Hallsensors darstellt, ist heutzutage mit einer Tiefe von einigen wenigen Mikrometern sehr dünn und wird mit dem Fortschritt in der Miniaturisierung der Transistoren dünner und dünner. Die Aufgabe muss deshalb bei jeder neuen Generation der IC Technologie neu gelöst werden.

Um den Offset eines Hallsensors zu reduzieren, sind zwei Standardmethoden bekannt, nämlich erstens die orthogonale Kopplung von mindestens zwei Hallsensoren, wobei die Kontakte des ersten Hallsensors gegenüber den Kontakten des zweiten Hallsensors "elektrisch um 90° verschoben" sind, und zweitens das Spinning Current Verfahren, bei dem die Strom-und Spannungskontakte des Hallsensors zyklisch vertauscht werden. Die orthogonale Kopplung wird auch als Parallelschaltung bezeichnet. Diese Verfahren sind beispielsweise bekannt aus dem Buch "Hall Effect Devices, Magnetic Sensors and Characterization of Semiconductors" von Dr. R.S. Popovic, Adam Hilger, ISBN 0-7503-0096-5 und aus der EPFL Thesis no. 3134 (2004) von Enrico Schurig. Aus der WO 03/036733 ist die gleichzeitige Anwendung der beiden Verfahren bekannt. Eine Parallelschaltung von zwei symmetrischen vertikalen Hallelementen ist auch aus der WO 2004/025742 bekannt.

Der Erfindung liegt die Aufgabe zugrunde, einen vertikalen Hallsensor zu entwickeln, dessen Offset möglichst gering ist. Die Figuren sind schematisch und nicht massstäblich gezeichnet.

Die genannte Aufgabe wird erfindungsgemäss gelöst durch die Merkmale des Anspruchs 1. Bevorzugte Ausführungsbeispiele sind in den abhängigen Ansprüchen definiert.

Die Erfindung wird nachfolgend anhand von Ausführungsbeispielen und anhand der Zeichnung näher erläutert.

Fig. 1, 2     zeigt einen erfindungsgemässen vertikalen Hallsensor in Aufsicht und in seitlicher Ansicht,
Fig. 3 bis 6     zeigen weitere Ausführungsbeispiele von erfindungsgemässen vertikalen Hallsensoren, und
Fig. 7     zeigt einen vertikalen Hall Sensor und eine elektronische Schaltung für den Betrieb des vertikalen Hallsensors gemäss der Spinning Current Methode.

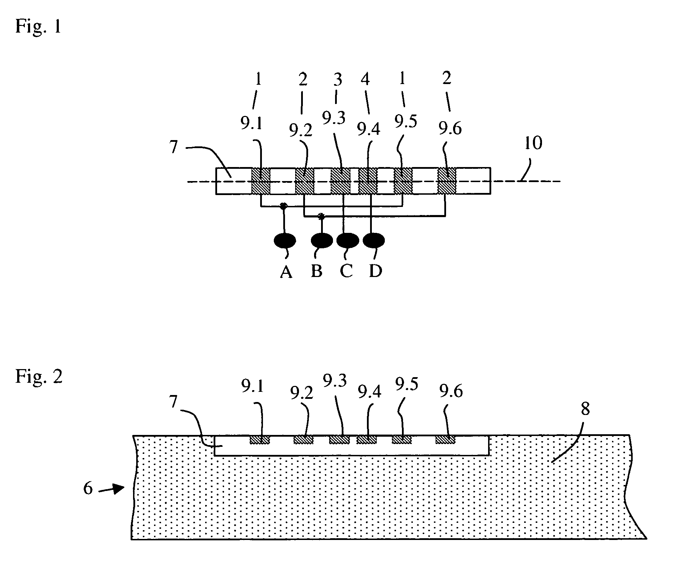

Die Fig. 1 und 2 zeigen schematisch in Aufsicht und in seitlicher Ansicht einen vertikalen Hallsensor, der in einen Halbleiterchip 6 integriert ist. Der vertikale Hallsensor umfasst eine elektrisch leitende Wanne 7 eines ersten Leitfähigkeitstyps, die in ein elektrisch leitendes Gebiet 8 eines zweiten Leitfähigkeitstyps eingebettet ist, und eine Anzahl n von Kontakten 9.1 bis 9.n, die die Wanne 7 kontaktieren. Die Gesamtheit der Kontakte 9.1 bis 9.n wird der Einfachheit halber als Kontakte 9 bezeichnet. Die Anzahl n der Kontakte 9 kann zwar im Minimum n = 6 betragen und jeden Wert n ≥ 6 annehmen, liegt mit Vorteil jedoch im Bereich von etwa n = 16 bis 32. Die Wanne 7 besteht vorzugsweise aus n-dotiertem Halbleitermaterial und das Gebiet 8 aus p-dotiertem Halbleitermaterial. Die Wanne 7 ist somit durch einen pn-Übergang elektrisch vom Gebiet 8 isoliert. Die n Kontakte 9 sind entlang einer Geraden 10 angeordnet. Die Wanne 7 und insbesondere die Kontakte 9 befinden sich an der für die Verdrahtung zugänglichen Oberfläche des Halbleiterchips 6. Die Kontakte 9 sind in der Regel hochdotierte Gebiete des ersten Leitfähigkeitstyps, die in der Regel gleich breit sind wie die Wanne 7, jedoch auch etwas breiter oder etwas schmaler sein können. Der Hallsensor ist empfindlich auf ein Magnetfeld, das parallel zur Oberfläche des Halbleiterchips 6 und senkrecht zur Geraden 10 verläuft, und gehört deshalb in die Klasse der vertikalen Hallsensoren. Der Halbleiterchip 6 enthält weiter eine Vielzahl von nicht dargestellten integrierten elektronischen Elementen, die eine elektronische Schaltung für den Betrieb des Hallsensors bilden.

Die Kontakte 9 sind nach einer Vorschrift elektrisch derart miteinander verbunden, dass sie vier Anschlüsse A, B, C und D bilden, die mit der elektronischen Schaltung verbunden sind, wobei zwei der vier Anschlüsse als Stromanschlüsse dienen, um den Hallsensor mit einem Strom zu beaufschlagen, und die anderen zwei der vier Anschlüsse als Spannungsanschlüsse dienen, um die Hallspannung abzugreifen. Die Vorschrift zum Verbinden der Kontakte 9 ist folgende: Wenn die Kontakte 9 ausgehend von einem der beiden äussersten Kontakte 9.1 oder 9.n, der Einfachheit halber dem Kontakt 9.1, fortlaufend und wiederholt mit den vier Ziffern 1, 2, 3 und 4 durchnummeriert werden, dann sind diejenigen Kontakte 9, denen die gleiche Ziffer zugeordnet ist, elektrisch miteinander verbunden. Diese Zuordnung kann mathematisch mithilfe der Modulo-Funktion (mod) wie folgt ausgedrückt werden:

$$\text{Ziffer (Kontakt 9.n)} = [(n-1) \bmod 4] + 1 \qquad\qquad (1).$$

d.h. dem Kontakt 9.n ist die Ziffer $[(n-1) \bmod 4] + 1$ zugeordnet. Es ist nämlich 0 mod 4 = 0, 1 mod 4 = 1, 2 mod 4 = 2, 3 mod 4 = 3, 4 mod 4 = 0, 5 mod 4 = 1, 6 mod 4 = 2, etc.

Die Zuordnung der Ziffern 1, 2, 3 und 4 zu den Kontakten 9.1 bis 9.6 ist in der Fig. 1 oben dargestellt, die entsprechende Verdrahtung ist in der Fig. 1 unten dargestellt.

Die Kontakte 9 sind nach einer weiteren Vorschrift, die ihre Abstände betrifft, entlang der Geraden 10 angeordnet: Der Abstand zwischen den Kontakten 9 kann konstant sein, bevorzugt ist jedoch folgendes: Ausgehend von der Mitte zwischen den beiden äussersten Kontakten 9.1 und 9.n nimmt der Abstand zwischen benachbarten Kontakten 9 von Kontakt zu Kontakt zu. Die Zunahme kann nach verschiedenen Regeln erfolgen, von denen drei vorgestellt werden.

Falls die Anzahl n der Kontakte 9 eine gerade Zahl ist, dann bezeichne die Grösse A den Abstand zwischen den beiden Kontakten 9.(n/2) und 9.(n/2 + 1) in der Mitte, falls die Anzahl n der Kontakte 9 eine ungerade Zahl ist, dann bezeichne die Grösse A den Abstand zwischen dem Kontakt 9.(n/2 + 1/2) in der Mitte und dem benachbarten Kontakt 9.(n/2 - 1/2) wie auch den Abstand zwischen dem Kontakt 9.(n/2 + 1/2) in der Mitte und dem benachbarten Kontakt 9.(n/2 + 3/2), die gleich gross sind.

Regel 1

Ausgehend vom einzigen Kontakt in der Mitte (wenn n eine ungerade Zahl ist) bzw. den beiden Kontakten in der Mitte (wenn n eine gerade Zahl ist) nimmt der Abstand zwischen benachbarten Kontakten in Richtung zu den äussersten Kontakten 9.1 bzw. 9.n hin von Kontakt zu Kontakt um einen konstanten Wert K zu.

Diese Regel ist in der Fig. 1 für n = 6 dargestellt. Der Abstand zwischen den beiden Kontakten 9.3 und 9.4 in der Mitte beträgt A. Der Abstand zwischen den beiden Kontakten 9.2 und 9.3, sowie der Abstand zwischen den beiden Kontakten 9.4 und 9.5 beträgt A + K. Der Abstand zwischen den beiden Kontakten 9.1 und 9.2, sowie der Abstand zwischen den beiden Kontakten 9.5 und 9.6 beträgt A + 2 * K.

Regel 2

Ausgehend vom einzigen Kontakt in der Mitte (wenn n eine ungerade Zahl ist) bzw. den beiden Kontakten in der Mitte (wenn n eine gerade Zahl ist) nimmt der Abstand zwischen benachbarten Kontakten in Richtung zu den äussersten Kontakten 9.1 bzw. 9.n hin von Kontakt zu Kontakt um einen konstanten Faktor L zu.

Für n = 6 ergibt sich: Der Abstand zwischen den beiden Kontakten 9.3 und 9.4 in der Mitte beträgt A. Der Abstand zwischen den beiden Kontakten 9.2 und 9.3. sowie der Abstand zwischen den beiden Kontakten 9.4 und 9.5 beträgt L * A. Der Abstand zwischen den beiden Kontakten 9.1 und 9.2, sowie der Abstand zwischen den beiden Kontakten 9.5 und 9.6 beträgt $L * (L * A) = L^2 * A$.

Regel 3

Ausgehend vom einzigen Kontakt in der Mitte (wenn n eine ungerade Zahl ist) bzw. den beiden Kontakten in der Mitte (wenn n eine gerade Zahl ist) wird der Abstand zwischen benachbarten Kontakten in Richtung zu den äussersten Kontakten 9.1 bzw. 9.n hin von Kontakt zu Kontakt zunächst um einen konstanten Faktor L vergrössert und dann ein konstanter Wert K dazu addiert.

Für n = 6 ergibt sich: Der Abstand zwischen den beiden Kontakten 9.3 und 9.4 in der Mitte beträgt A. Der Abstand zwischen den beiden Kontakten 9.2 und 9.3, sowie der Abstand zwischen den beiden Kontakten 9.4 und 9.5 beträgt L * A + K. Der Abstand zwischen den beiden Kontakten 9.1 und 9.2, sowie der Abstand zwischen den beiden Kontakten 9.5 und 9.6 beträgt L * (L * A + K) + K.

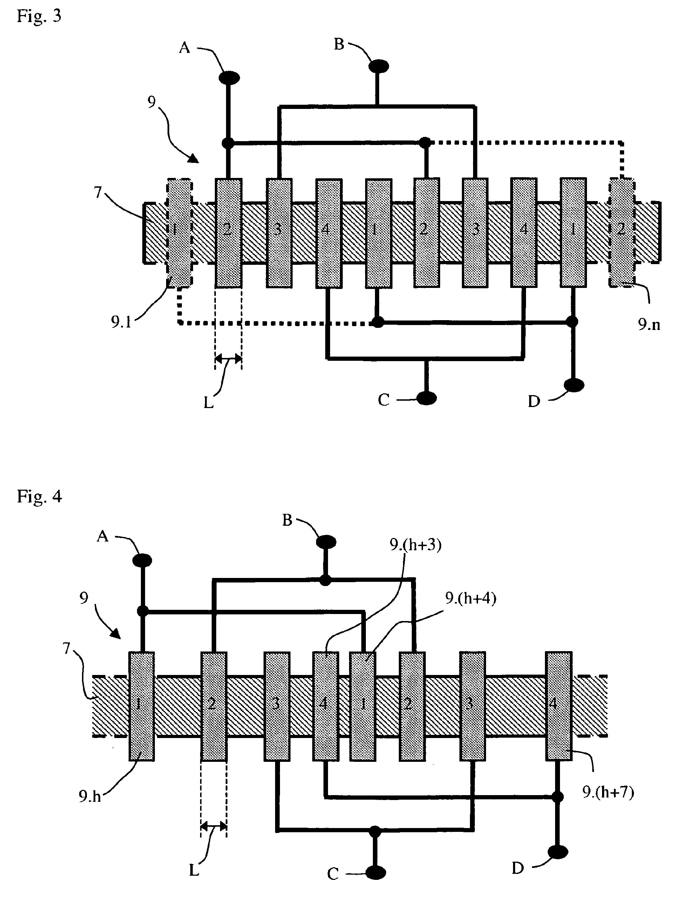

Die Fig. 3 bis 6 zeigen weitere Ausführungsbeispiele, die alle etwa den gleichen Aufbau haben, sich jedoch in gewissen Merkmalen unterscheiden. Diese Figuren zeigen die Wanne 7, den mittleren Bereich des vertikalen Hallsensors und - illustriert durch gestrichelte Linien - wie es weitergeht, wenn mehr als die mit fester Linie dargestellten Kontakte 9 vorhanden sind. Jedem der Kontakte 9 ist eine Ziffer 1, 2, 3 oder 4 zugeordnet gemäss der oben angegebenen Vorschrift (1). Diejenigen Kontakte 9, denen die gleiche Ziffer zugeordnet ist, sind elektrisch miteinander verbunden, und zu einem der vier Anschlüsse A, B, C oder D geführt.

Den Beispielen der Fig. 3 bis 5 ist gemeinsam, dass alle Kontakte 9 die gleiche Länge L aufweisen.

Die Fig. 3 zeigt einen vertikalen Hallsensor, bei dem der Abstand zwischen den Kontakten 9 einen konstanten Wert hat. Gezeigt sind zudem die beiden Endbereiche des vertikalen Hallsensors mit den beiden äussersten Kontakten 9.1 bzw. 9.n. Die Anzahl n der Kontakte 9 kann jeden beliebigen Wert n ≥ 6 annehmen, wobei der Wert n eine gerade oder eine ungerade Zahl sein kann. Im Beispiel ist dem äussersten linken Kontakt 9.1 die Ziffer 1, dem äussersten rechten Kontakt 9.n die Ziffer 2 zugeordnet. Welche Ziffer diesen Kontakten 9.1 bzw. 9.n zugeordnet werden muss, hängt vom Wert n ab. In dem in der Fig. 3 dargestellten Fall ist der äusserste linke Kontakt 9.1 mit denjenigen Kontakten 9 zu verbinden, denen die Ziffer 1 zugeordnet ist, und der äusserste rechte Kontakt 9.n ist mit denjenigen Kontakten 9 zu verbinden, denen die Ziffer 2 zugeordnet ist.

Die Fig. 4 zeigt einen vertikalen Hallsensor, bei dem in der Mitte zwei Kontakte in einem vorbestimmten Abstand zueinander angeordnet sind und bei dem ausgehend von der Mitte der Abstand zwischen den Kontakten 9 von Kontakt zu Kontakt in beiden Richtungen zu den Endbereichen hin zunimmt. Die Anzahl n der Kontakte ist bevorzugt eine gerade Zahl. Die beiden Kontakte in der Mitte sind mit dem Bezugszeichen 9.(h+3) und 9.(h+4) bezeichnet. Die Zahl h ist nur ein Platzhalter, hängt aber von der Anzahl n der Kontakte 9 ab.

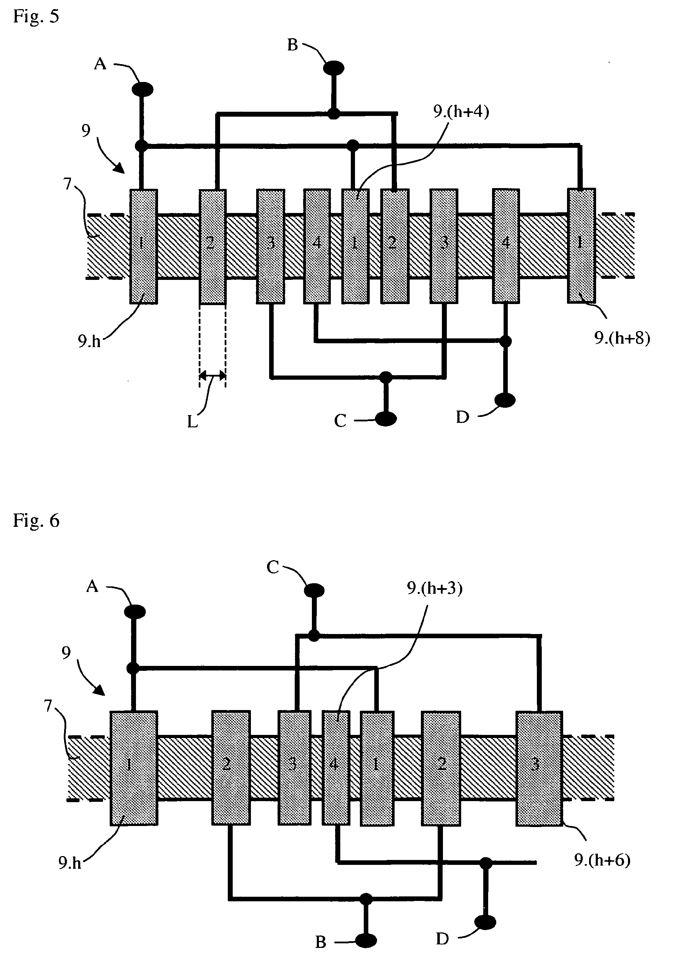

Die Fig. 5 zeigt einen vertikalen Hallsensor, bei dem in der Mitte ein einziger Kontakt angeordnet ist und bei dem ausgehend von diesem mittleren Kontakt der Abstand zwischen den Kontakten 9 von Kontakt zu Kontakt in beiden Richtungen zu den Endbereichen hin zunimmt. Die Anzahl der Kontakte ist bevorzugt eine ungerade Zahl. Der mittlere Kontakt ist mit dem Bezugszeichen 9.(h+4) bezeichnet.

Die Fig. 6 zeigt einen vertikalen Hallsensor, der ähnlich dem in der Fig. 5 gezeigten vertikalen Hallsensor ist, jedoch mit dem Unterschied, dass die Länge der Kontakte 9 mit zunehmendem Abstand vom mittleren Kontakt 9.(h+4) zunimmt.

Falls die Anzahl n der Kontakte eine ungerade Zahl ist, dann sind die Kontakte 9 bezüglich des einzigen mittleren Kontakts bevorzugt symmetrisch in der Wanne 7 angeordnet. Falls die Anzahl n der Kontakte eine gerade Zahl ist, dann sind die Kontakte 9 bezüglich der beiden mittleren Kontakte bevorzugt symmetrisch in der Wanne 7 angeordnet.

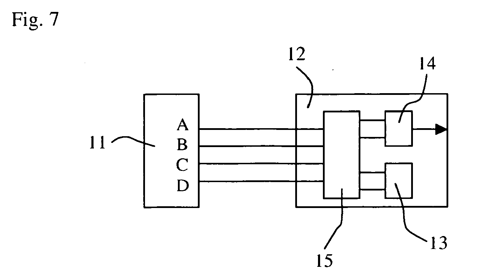

Die erfindungsgemässen vertikalen Hallsensoren werden vorzugsweise mit der Spinning Current Methode betrieben, bei der die Strom- und Spannungskontakte in zwei oder vier Phasen zyklisch vertauscht werden. Die Spinning Current Methode ist aus der Literatur gut bekannt und beispielsweise im Artikel von P J A Munter, "A low-offset spinning-current Hall plate", Sensors and Actuators A21-A23 (1990) 743-746 wie auch in der WO 03/036733 beschrieben, auf die hier explizit verwiesen wird. Die Fig. 7 zeigt einen erfindungsgemässen vertikalen Hallsensor 11 mit den vier Anschlüssen A, B, C und D, die über Leitungen mit einer elektronischen Schaltung 12 verbunden sind, die den Betrieb des Hallsensors 11 mit der Spinning Current Methode ermöglicht. Die elektronische Schaltung 12 enthält eine Stromquelle 13, einen Spannungsmesser 14, einen Multiplexer 15 und weitere Schaltungsblöcke. Der Multiplexer 15 dient dazu, gemäss einem vorbestimmten Spinning Current Schema zyklisch jeweils zwei der vier Anschlüsse A, B, C und D mit den zwei Anschlüssen der Stromquelle 13 und die anderen beiden der vier Anschlüsse A, B, C und D mit den zwei Anschlüssen des Spannungsmessers 14 zu verbinden. Der Hall Sensor 11 und die elektronische Schaltung 12 sind bevorzugt im gleichen Halbleiterchip integriert.

**Patentansprüche**

1. Vertikaler Hallsensor, der in einen Halbleiterchip (6) integriert ist, mit einer elektrisch leitenden Wanne (7) eines ersten Leitfähigkeitstyps, die in ein elektrisch leitendes Gebiet (8) eines zweiten Leitfähigkeitstyps eingebettet ist, und mit elektrischen Kontakten (9), die entlang einer Geraden (10) an der Oberfläche der elektrisch leitenden Wanne (7) angeordnet sind, **dadurch gekennzeichnet, dass** die Anzahl n der Kontakte (9) mindestens n = 6 beträgt und dass, wenn alle Kontakte (9) ausgehend von einem der beiden äussersten Kontakte durchgehend (9.1) fortlaufend und wiederholt mit den Ziffern 1, 2, 3 und 4 durchnummeriert werden, diejenigen Kontakte (9), denen die gleiche Ziffer zugeordnet ist, elektrisch miteinander verbunden sind.

2. Vertikaler Hallsensor nach Anspruch 1, **dadurch gekennzeichnet, dass** ausgehend von der Mitte zwischen den beiden äussersten Kontakten (9.1, 9.n) der Abstand zwischen den Kontakten (9) von Kontakt zu Kontakt zunimmt.

3. Vertikaler Hallsensor nach Anspruch 2, **dadurch gekennzeichnet, dass** der besagte Abstand um einen vorbestimmten Faktor zunimmt.

4. Vertikaler Hallsensor nach Anspruch 2, **dadurch gekennzeichnet, dass** der besagte Abstand um einen konstanten Wert zunimmt.

**5.** Vertikaler Hallsensor nach Anspruch 2, **dadurch gekennzeichnet, dass** der besagte Abstand um einen vorbestimmten Faktor vergrössert und dann ein konstanter Wert dazu addiert wird.

**6.** Vertikaler Hallsensor nach einem der Ansprüche 1 bis 5, **dadurch gekennzeichnet, dass** ausgehend von der Mitte zwischen den beiden äussersten Kontakten (9.1, 9.n) die Länge der Kontakte von Kontakt zu Kontakt zunimmt.

**7.** Vertikaler Hallsensor nach einem der Ansprüche 1 bis 6, weiter umfassend eine elektronische Schaltung (12), die konfiguriert ist für den Betrieb des Hallsensors mit der Spinning Current Methode.

## Claims

**1.** Vertical Hall sensor which is integrated in a semiconductor chip (6), having an electrically conductive well (7) of a first conductivity type which is embedded in an electrically conductive region (8) of a second conductivity type, and electric contacts (9) which are arranged along a straight line (10) on the surface of the electrically conductive well (7), **characterized in that** the number n of the contacts (9) is at least n = 6, and that when starting from one of the two outermost contacts (9.1) all contacts (9) are numbered through throughout continuously and repeatedly with the numerals 1, 2, 3 and 4, the contacts (9) to which the same numeral is assigned are electrically connected with each other.

**2.** Vertical Hall sensor according to claim 1, **characterized in that**, starting from the middle between the two outermost contacts (9.1, 9.n), the distance between the contacts (9) increases from contact to contact.

**3.** Vertical Hall sensor according to claim 2, **characterized in that** the said distance increases by a predetermined factor.

**4.** Vertical Hall sensor according to claim 2, **characterized in that** the said distance increases by a constant value.

**5.** Vertical Hall sensor according to claim 2, **characterized in that** the said distance is increased by a predetermined factor and a constant value is added thereto.

**6.** Vertical Hall sensor according to any of claims 1 to 5, **characterized in that** starting from the middle between the two outermost contacts (9.1, 9.n), the length of the contacts increases from contact to contact.

**7.** Vertical Hall sensor according to any of claims 1 to 6, further comprising an electronic circuit (12) configured to operate the vertical Hall sensor according to the spinning current method.

## Revendications

**1.** Capteur à effet Hall vertical, qui est intégré dans une puce de semi-conducteur (6) et qui comprend un bac (7) à conduction électrique d'un premier type de conduction qui est placé dans une zone électriquement conductible (8) d'un second type de conduction, et qui est agencé avec des contacts électriques (9) qui sont agencés le long d'une ligne droite (10) à la surface du bac (7) à conduction électrique, **caractérisé en ce que** le nombre « n » de contacts (9) comporte au moins n = 6 et **en ce que** lorsque tous les contacts (9) sont numérotés de manière répétée avec les chiffres 1, 2, 3 et 4 en partant d'un des deux contacts extérieurs (9.1) en continu et de manière suivie, lesdits contacts (9) auxquels le même chiffre est attribué sont connectés électriquement entre eux.

**2.** Capteur à effet Hall vertical selon la revendication 1, **caractérisé en ce que**, en partant du milieu entre les deux contacts extérieurs (9.1, 9.n), la distance entre les contacts (9) augmente d'un contact à l'autre consécutivement.

**3.** Capteur à effet Hall vertical selon la revendication 2, **caractérisé en ce que** ladite distance augmente d'un facteur prédéterminé.

**4.** Capteur à effet Hall vertical selon la revendication 2, **caractérisé en ce que** ladite distance augmente d'une valeur constante.

**5.** Capteur à effet Hall vertical selon la revendication 2, **caractérisé en ce que** ladite distance est agrandie d'un facteur prédéterminé et est ensuite additionnée d'une valeur constante.

6. Capteur à effet Hall vertical selon l'une des revendications 1 à 5, **caractérisé en ce que**, en partant du milieu entre les deux ccontacts extérieurs (9.1, 9.n), la longueur des contacts augmente d'un contact vers un contact.

7. Capteur à effet Hall vertical selon l'une des revendications 1 à 6, comprenant en outre un circuit électronique (12), qui est configuré pour le fonctionnement du capteur à effet Hall avec la méthode à courant tournant.

Fig. 1

Fig. 2

Fig. 3

Fig. 4

Fig. 5

Fig. 6

Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 03036733 A

- WO 2004025742 A

**In der Beschreibung aufgeführte Nicht-Patentliteratur**

- Hall Effect Devices, Magnetic Sensors and Characterization of Semiconductors. **Buch ; von Dr. R.S. Popovic.** Hall Effect Devices, Magnetic Sensors and Characterization of Semiconductors. Adam Hilger

- **von Enrico Schurig.** *der EPFL Thesis no. 3134,* 2004
- **von P J A Munter.** A low-offset spinning-current Hall plate. *Sensors and Actuators,* 1990, vol. A21-A23, 743-746